# EUROPEAN PATENT APPLICATION

(11) **EP 2 876 694 A1**
(43) Date of publication of application: **27.05.2015**
(21) Application number: 14193726.8
(22) Date of filing: 18.11.2014
(51) Int. Cl.: H01L 31/0749, H01L 31/0392

(54) **Solar cell**

(30) Priority: 20.11.2013 KR 20130141633
(71) Applicant: Samsung SDI Co., Ltd., Yongin-si, Gyeonggi-do (KR)
(72) Inventor: Kim, Young-Su, 446-902 Gyeonggi-do (KR); Nam, Jung-Gyu, 446-902 Gyeonggi-do (KR); Lee, Ji-Won, 446-902 Gyeonggi-do (KR)
(74) Representative: Mounteney, Simon James

(57) **Abstract**

A solar cell according to an example embodiment includes: a substrate; a first electrode formed on the substrate; a photoactive layer formed on the first electrode and including sodium and potassium; a buffer layer formed on the photoactive layer; and a second electrode formed on the buffer layer. The photoactive layer includes an area where a content of sodium is greater than a content of potassium.

## Description

### BACKGROUND

### 1. Field

The invention relates generally to a solar cell.

### 2. Description of the Related Art

As a photovoltaic element that converts solar energy to electrical energy, a solar cell array is gaining much interest as an unlimited and non-polluting next generation energy source.

A solar cell array includes a p-type semiconductor and an n-type semiconductor, and when solar energy is absorbed at a photoactive layer, an electron-hole pair (EHP) is generated, the generated electrons and holes move to the n-type semiconductor and the p-type semiconductor respectively, and are collected by electrodes, to thereby be used (utilized) as electrical energy.

As the photoactive layer, a compound semiconductor including group I-III-VI elements may be used (utilized). The compound semiconductor may realize a high efficiency solar cell array with a high light absorption coefficient and high optical stability.

Meanwhile, an increase of a defect in an interface where a PN junction is formed causes recombination of electrons and holes so that the open circuit voltage (Voc) is decreased.

The above information disclosed in this Background section is only for enhancement of understanding of the background of the described technology and therefore it may contain information that does not form the prior art that is already known in this country to a person of ordinary skill in the art.

### SUMMARY

The invention sets-out to provide a solar cell that can increase Voc by reducing recombination of electrons and holes in an interface where a PN junction is formed.

A solar cell according to an example embodiment of the invention includes: a substrate; a first electrode on the substrate; a photoactive layer on the first electrode and including sodium and potassium; a buffer layer on the photoactive layer; and a second electrode on the buffer layer. The photoactive layer includes an area where a content of sodium is greater than a content of potassium. The content of sodium may be configured with the content of potassium in the photoactive layer to passivate a defect caused by a doner in the photoactive layer.

A total amount of sodium and potassium included in the photoactive layer may be greater than 1 * 10¹⁹/cm³.

The photoactive layer may include a first area adjacent to the first electrode and a second area adjacent to the second electrode, a content of sodium may be greater than a content of potassium in the second area, and a content of sodium may be equal to or smaller than a content of potassium in the first area.

A depth of the second area may be greater than a width of a space charge region (SCR).

The first electrode may include molybdenum, and the second electrode may include IZO, ITO, and/or AZO.

The photoactive layer may include a CIGS-based material, and the substrate may include soda-lime glass.

According to an embodiment of the present invention, a method of forming a solar cell includes forming a first electrode on a substrate; forming a photoactive layer on the first electrode and to comprise sodium and potassium; forming a buffer layer on the photoactive layer; and forming a second electrode on the buffer layer, wherein the forming of the photoactive layer comprises forming an area of the photoactive layer where a content of sodium is greater than a content of potassium to passivate a defect caused by a doner in the photoactive layer. The forming of the photoactive layer may include forming a first area adjacent to the first electrode and a second area adjacent to the second electrode, wherein a content of sodium is greater than a content of potassium in the second area, and a content of sodium is equal to or smaller than a content of potassium in the first area. A depth of the second area may be greater than a width of a space charge region to reduce recombination of electrons and holes.

According to the example embodiments of the invention, Voc of the solar cell can be increased.

At least some of the above and other features of the invention are set-out in the claims.

### BRIEF DESCRIPTION OF THE DRAWINGS

FIG. 1 is a cross-sectional view of a solar cell according to an example embodiment of the invention.
FIG. 2 is a cross-sectional view of a solar cell according to another example embodiment of the invention.

### DETAILED DESCRIPTION

The present invention will be described more fully hereinafter with reference to the accompanying drawings, in which example embodiments of the invention are shown. As those skilled in the art would realize, the described embodiments may be modified in various different ways, all without departing from the scope of the present invention.

In the drawings, the thickness of layers, films, panels, regions, etc., are exaggerated for clarity. Like reference numerals designate like elements throughout the specification. It will be understood that when an element such as a layer, film, region, or substrate is referred to as being "on" another element, it may be directly on the other element, or intervening elements may also be present. In contrast, when an element is referred to as being "directly on" another element, there are no intervening elements present. Expressions such as "at least one of," when preceding a list of elements, modify the entire list of elements and do not modify the individual elements of the list. Further, the use of "may" when describing embodiments of the present invention refers to "one or more embodiments of the present invention."

Hereinafter, a solar cell will be described in more detail with reference to the accompanying drawings.

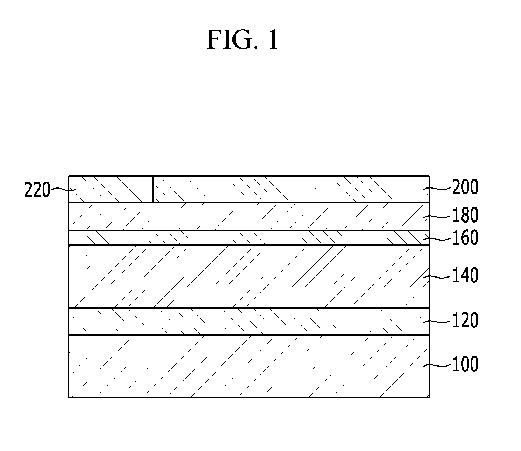

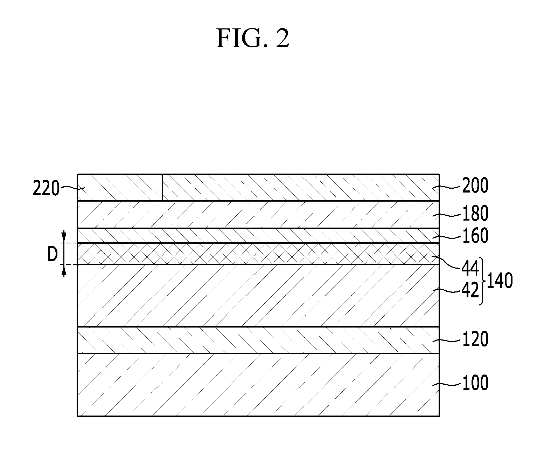

FIG. 1 is a cross-sectional view of a solar cell according to an example embodiment of the invention, and FIG. 2 is a cross-sectional view of a solar cell according to another example embodiment of the invention.

As shown in FIG. 1, a solar cell according to the present example embodiment includes a substrate 100, a first electrode 120 formed on the substrate 100, a photoactive layer 140 formed on the first electrode 120, a buffer layer 160 formed on the photoactive layer 140, a second electrode 180 formed on the buffer layer 160, an anti-reflection layer 200 formed on the second electrode 180, and a grid electrode 220 connected with the second electrode 180.

The substrate 100 may be made of a transparent insulating material, for example, soda-lime glass, and the soda-lime glass may include sodium (Na) and potassium (K).

The first electrode 120 may be made of a metal having a suitable (e.g., an excellent) heat resistance characteristic, a suitable (e.g., an excellent) electrical contact characteristic with respect to a material that forms the photoactive layer 140, a suitable (e.g., an excellent) electric conductivity, and a suitable (e.g., an excellent) interface adherence with the substrate 100. For example, the first electrode 120 may be made of molybdenum (Mo).

The photoactive layer 140 and the buffer layer 160 are formed on the first electrode 120.

As a p-type CIGS-based (copper indium gallium selenide-based) semiconductor, the photoactive layer 140 may include selenium (Se) and/or sulfur (S). For example, the photoactive layer 140 may include Cu(In₁₋ₓ,Gaₓ)(Se₁₋ₓ,Sₓ) as a group I-III-VI-based semiconductor compound, and may be a compound semiconductor having a composition of 0≤x≤1. The photoactive layer 140 may have a single phase of which a composition in the compound semiconductor is substantially uniform. For example, the photoactive layer 140 may include CuInSe₂, CuInS₂, Cu(In,Ga)Se₂, (Ag,Cu)(In,Ga)Se₂, (Ag,Cu)(In,Ga)(Se,S)₂, Cu(In,Ga)(Se,S)₂, or Cu(In,Ga)S₂.

The photoactive layer 140 may include sodium (Na) and potassium (K), and may include an area where a content of sodium is greater than a content of potassium. In this case, the sum of the content of sodium and the content of the potassium may be greater than 1 * 10¹⁹atoms/cm³.

In FIG. 1, the area where the content of sodium is greater than the content of potassium corresponds to the entire area of the photoactive layer, but as shown in FIG. 2, the area of the photoactive layer may be divided into a plurality of areas depending on the relative content of sodium.

Referring to FIG. 2 and according to one embodiment, an area that is adjacent to the first electrode 120 is referred to as a first area 42, and an area that is adjacent to the second electrode 180 is referred to as a second area 44 in the photoactive layer 140. Here, a content of sodium of the second area 44 may be greater than a content of potassium of the second area 44. In addition, a content of sodium of the first area 42 may be equal to or smaller than a content of potassium of the first area 42. Further, a depth (i.e., thickness) D of the second area 44 may be greater than the width of a space charge region.

In order to include sodium in the photoactive layer 140, a sodium ion may be injected when forming the photoactive layer 140, or ion doping may be performed after forming the photoactive layer 140 so as to control a content of sodium included in the photoactive layer 140.

Meanwhile, when the substrate 100 is made of soda-lime glass, sodium and potassium included in the substrate 100 may be dispersed into the photoactive layer 140, and therefore the amount of dispersion should be considered in the ion doping.

The buffer layer 160 reduces an energy gap difference between the photoactive layer 140 and the second electrode 180. The buffer layer 160 may be made of an n-type semiconductor material having high light transmittance, for example, CdS, ZnS, and/or InS.

The second electrode 180 is formed on the buffer layer 160.

The second electrode 180 may be made of a material having high light transmittance and suitable (e.g., excellent) electrical conductivity, and for example, may be formed in a single layer or a multilayer (for example, a multiplayer of ITO/IZO/ZnO). The light transmittance may be over about 80 %. In one embodiment, the ZnO layer has a low resistance value by being doped with aluminum (Al) and/or boron (B).

When the second electrode 180 is formed as a multilayer, an ITO layer having an excellent electro-optical characteristic may be layered on a ZnO layer, or an n-type ZnO layer having a low resistance value may be layered on an i-type (intrinsic) undoped ZnO layer.

The second electrode 180 is an n-type semiconductor, and forms a PN junction with the photoactive layer 140, which is a p-type semiconductor.

The anti-reflection layer 200 may improve efficiency of the solar cell by reducing a reflection loss of solar light, and may be omitted as necessary. The anti-reflection layer 200 may be made of MgF₂.

The grid electrode 220 is formed at one side of the anti-reflection layer 200 while contacting the second electrode 180, and collects a current from the surface of the solar cell. The grid electrode 220 may be made of aluminum (Al), nickel (Ni), and/or an alloy thereof, and may be omitted as necessary.

When the solar cell is formed as in the present example embodiment, charges generated by solar light are collected through the grid electrode 220.

In addition, a decrease of Voc of the solar cell may be reduced or prevented by controlling the content of sodium as in the example embodiment.

In the solar cell, the degree of recombination may be changed depending on a condition of the interface that forms the PN junction, and the Voc is significantly reduced as the recombination is increased. Particularly, the Voc may be decreased as recombination in the periphery of the space charge region is increased.

However, when an area where the content of sodium is greater than a content of potassium is formed as in the present example embodiment, passivation of a defect caused by a donor in the photoactive layer is carried out due to sodium so that recombination of carriers is reduced.

In addition, when the depth of the area where the content of the sodium is greater than the content of the potassium is greater than the width of the space charge region as in the present example embodiment, recombination on the periphery of the space charge region is reduced, thereby reducing or preventing the decrease of Voc.

Table 1 shows a result of measurement of Voc and fill factor (EFF) of Comparative Examples 1 and 2 according to a comparable art and Examples 1 and 2 according to embodiments of the present invention.

Comparative Example 1, Comparative Example 2, Example 1, and Example 2 have the same layer structure but are different in the ratio of sodium and potassium in a space charge region.

Comparative Example 1 has a relationship of a content of sodium less than (<) a content of potassium, Comparative Example 2 has a relationship of a content of sodium same as (=) a content of potassium, Examples 1 and 2 respectively have a relationship of a content of sodium greater than (>) a content of potassium, and a content of sodium of Example 1 greater than (>) a content of sodium of Example 2.

**Table 1**

| | Width of SCR (um) | Voc | EFF |
|---|---|---|---|
| Comparative Example 1 | 0.22 | 0.5227 | 10.8055 |
| Comparative Example 2 | 0.3 | 0.4934 | 7.5575 |
| Example 1 | 0.31 | 0.6439 | 16.449 |
| Example 2 | 0.31 | 0.6251 | 15.4664 |

Referring to Table 1, Voc of Comparative Example 1 and Voc of Comparative Example 2 are respectively 0.5227 and 0.4934, but Voc of Example 1 and Voc of Example 2 are respectively 0.6439 and 0.6251, which are greater compared to that of the comparable art.

In addition, EFF of Comparative Example 1 and EFF of Comparative Example 2 are respectively 10.0558 and 7.5575, but EFF of Example 1 and EFF of Example 2 are respectively 16.449 and 15.4664, which are greater compared to that of the comparable art.

In addition, a substrate of Example 1 and a substrate of Example 2 respectively have different contents of sodium, but contents of sodium are greater than contents of potassium in the two substrates so that Voc and EFF are increased compared to the Comparative Examples 1 and 2.

While this disclosure has been described in connection with what are presently considered to be practical example embodiments, it is to be understood that the invention is not limited to the disclosed embodiments, but, on the contrary, is intended to cover various modifications and equivalent arrangements included within the scope of the present invention, as defined in the appended claims, and equivalents thereof.

## Claims

1. A solar cell comprising:
a substrate;
a first electrode on the substrate;
a photoactive layer on the first electrode and comprising sodium and potassium;
a buffer layer on the photoactive layer; and
a second electrode on the buffer layer,
wherein the photoactive layer comprises an area where a content of sodium is greater than a content of potassium.

2. A solar cell according to claim 1, wherein a total amount of sodium and potassium comprised in the photoactive layer is greater than 1*10¹⁹atoms/cm³.

3. A solar cell according to claim 1 or 2, wherein the photoactive layer comprises a first area adjacent to the first electrode and a second area adjacent to the second electrode,
a content of sodium is greater than a content of potassium in the second area, and
a content of sodium is equal to or smaller than a content of potassium in the first area.

4. A solar cell according to claim 3, wherein a depth of the second area is greater than a width of a space charge region.

5. A solar cell according to any preceding claim, wherein the first electrode comprises molybdenum and the second electrode comprises IZO, ITO, and/or AZO.

6. A solar cell according to any preceding claim, wherein the photoactive layer comprises a CIGS-based material.

7. A solar cell according to any preceding claim, wherein the substrate is formed of soda-lime glass.

8. A method of forming a solar cell, the method comprising:
forming a first electrode on a substrate;
forming a photoactive layer that comprises sodium and potassium on the first electrode;
forming a buffer layer on the photoactive layer; and
forming a second electrode on the buffer layer,
wherein the forming of the photoactive layer comprises forming an area of the photoactive layer where a content of sodium is greater than a content of potassium.

9. A method according to claim 8, wherein the forming of the photoactive layer comprises forming a first area adjacent to the first electrode and a second area adjacent to the second electrode,
wherein a content of sodium is greater than a content of potassium in the second area, and
a content of sodium is equal to or smaller than a content of potassium in the first area.

10. A method according to claim 9, wherein a depth of the second area is greater than a width of a space charge region to reduce recombination of electrons and holes.
